# EUROPEAN PATENT APPLICATION

(11) **EP 2 983 460 A1**
(43) Date of publication of application: **10.02.2016**
(21) Application number: 14306249.5
(22) Date of filing: 07.08.2014
(51) Int. Cl.: H05K 7/20

(54) **Apparatus, and method for cooling an electronics chassis**

(71) Applicant: ALCATEL LUCENT, 92100 Boulogne-Billancourt (FR)
(72) Inventor: Martin, Adam, Swindon, Wiltshire SN5 7DJ (GB); Akalanne, Lucius, Swindon, Wiltshire SN5 7YT (GB); Kerslake, Simon, Swindon, Wiltshire SN5 7YT (GB)
(74) Representative: Lichota, Catherine Margaret Timmis

(57) **Abstract**

An apparatus, comprises an electronics chassis, said electronics chassis being capable of generating heat during operation, the electronics chassis comprising an upper end, a lower end and at least one side face between the ends, and a wind collector comprising a heat-exchanger portion and a wind-deflector portion, said wind collector mounted to said electronics chassis such that said heat-exchanger portion faces and extends along the one side face of said electronics chassis, said wind-deflector portion extending beyond one of the ends of said electronics chassis and being able to direct part of an external air flow between the heat-exchanger portion and the one side face.

## Description

### TECHNICAL FIELD

The present invention relates to an apparatus, and a method for electronics chassis cooling.

### BACKGROUND

A type of electronics enclosure is a remote radio head of a distributed base station. Remote radio head technology allows base station components to be distributed in multiple locations, enabling more flexible deployments by reducing real estate and space requirements. A remote radio head (RRH) contains radio frequency (RF) components in a relatively small single unit that can be deployed at a location remote from a main base band unit (BBU). The remote radio head can be mounted close to an antenna, using fibre optic links for example, to reduce feeder losses and to improve coverage. An outdoor remote radio head is typically mounted on a pole or on the roof or side of a building; however, a remote radio head can also be located indoors or within a confined space such as a tunnel or elevator shaft.

### SUMMARY

According to an embodiment, there is provided an apparatus, comprising an electronics chassis capable of generating heat during operation and which comprises an upper end, a lower end and at least one side face between the ends, and a wind collector comprising a heat-exchanger portion and a wind-deflector portion. The wind collector is mounted to the electronics chassis such that the heat-exchanger portion faces and extends along the one side face of said electronics chassis, with the wind-deflector portion extending beyond one of the ends of the electronics chassis and being able to direct part of an external air flow between the heat-exchanger portion and the one side face. The heat-exchanger portion and the wind-deflector portion can form a continuous surface facing the electronics chassis.

The heat-exchanger portion and the wind-deflector portion each have a width direction, and the orientation of the width direction of the wind-deflector portion relative to the width direction of the heat-exchanger portion is adjustable. The heat-exchanger portion can be manually configurable to adjust the orientation of the wind-deflector portion relative to the heat-exchanger portion. The wind collector can comprise a rotatable mouth portion rotatably connected to the wind-deflector portion. The mouth portion can include a wind vane rigidly connected thereto. The rotatable mouth portion can be rotatable through 360 degree rotation. The wind collector can therefore be positioned, or have its position modified, to enable it or the mouth thereof to present an opening to prevailing wind in order to enable an airflow to be established using collected wind so as to cool the electronics chassis.

At least one internal divider can be provided within a fluid conduit between the rotatable mouth portion and the heat exchanger portion whereby to distribute collected wind across the width of the electronics chassis. The wind collector can be monolithic.

The apparatus can further comprising a solar thermal collector defining a plurality of channels, wherein the solar thermal collector mounted to said electronics chassis such that it is located above a side face of the electronics chassis. The channels can extend substantially parallel to the plane of the said side face. The solar thermal collector can be provided with a thermal insulation portion. In an example, the thermal insulation portion can be an air gap.

Respective ones of the channels of the thermal collector can be provided with a pair of wings arranged to extend outwardly from the side wall of the tubular channel.

The heat-exchanger portion of wind collector can be substantially planar, and the wind-deflector portion can extend from the heat-exchanger portion to direct the airflow through an angle in the range 45-90 degrees. It will be appreciated that other suitable angles to direct the airflow can be used.

According to an embodiment, there is provided a method for cooling an electronics chassis, comprising providing a wind collector including a heat exchanger portion and wind deflector portion mountable to the electronics chassis such that the heat exchanger portion faces and extends along one side face of the electronics chassis, and positioning the wind deflector portion so as to direct wind between the heat exchanger portion and the one side face.

In an embodiment, the electronics enclosure is a remote radio head.

Different aspects and embodiments of the invention may be used separately or together.

Further particular and preferred aspects of the present invention are set out in the accompanying independent and dependent claims. Features of the dependent claims may be combined with the features of the independent claims as appropriate, and in combinations other than those explicitly set out in the claims.

### BRIEF DESCRIPTION OF THE DRAWINGS

The present invention will now be described, by way of example only, with reference to the accompanying drawings, in which:
Figure 1 is a schematic representation of a remote radio head (RRH);
Figure 2 shows an apparatus comprising a wind collector according to a first embodiment;
Figure 3 shows an apparatus comprising a wind collector according to a second embodiment;
Figure 4 shows an apparatus comprising a wind collector according to a third embodiment;
Figure 5 shows an apparatus comprising a wind collector according to a fourth embodiment;
Figure 6 shows an additional feature of the wind collector shown in Figure 5;
Figure 7 shows an apparatus comprising a wind collector according to the first embodiment and a solar collector; and
Figure 8 is a schematic representation of a portion of a wind collector according to an example.

### DESCRIPTION

Example embodiments are described below in sufficient detail to enable those of ordinary skill in the art to make and use the systems and processes herein described. It is important to understand that embodiments can be provided in many alternate forms and should not be construed as limited to the examples set forth herein.

Accordingly, while embodiments can be modified in various ways and take on various alternative forms, specific embodiments thereof are shown in the drawings and described in detail below as examples. There is no intent to limit to the particular forms disclosed. On the contrary, all modifications, equivalents, and alternatives falling within the scope of the appended claims should be included. Elements of the example embodiments are consistently denoted by the same reference numerals throughout the drawings and detailed description where appropriate.

The terminology used herein to describe embodiments is not intended to limit the scope. The articles "a," "an," and "the" are singular in that they have a single referent, however the use of the singular form in the present document should not preclude the presence of more than one referent. In other words, elements referred to in the singular can number one or more, unless the context clearly indicates otherwise. It will be further understood that the terms "comprises," "comprising," "includes," and/or "including," when used herein, specify the presence of stated features, items, steps, operations, elements, and/or components, but do not preclude the presence or addition of one or more other features, items, steps, operations, elements, components, and/or groups thereof.

Unless otherwise defined, all terms (including technical and scientific terms) used herein are to be interpreted as is customary in the art. It will be further understood that terms in common usage should also be interpreted as is customary in the relevant art and not in an idealized or overly formal sense unless expressly so defined herein.

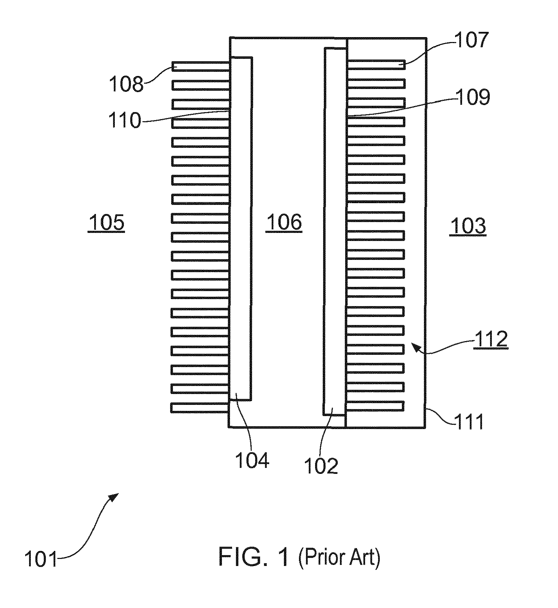

A schematic representation of an electronics chassis in the form of a remote radio head (RRH) 101 is shown in Figure 1. The substantially rectangular cuboid body of the remote radio head comprises a pair of half-shell elements, which when brought together with top and bottom weatherised seals, define a hermetically sealed internal chamber. The remote radio head 101 houses internally first equipment 102 towards one side 103 and second equipment 104 towards the other, opposite side 105, with an internal volume of waste space 106 between. A series of external heat sink fins 107, 108 is provided along the external surfaces 109, 110 of each side 103, 105 respectively to effect a degree of cooling. Waste heat trapped within the hermetically sealed remote radio head 101 can affect the operation and reliability of housed equipment 102, 104.

In view of, for example, the different weather conditions and environments in which the electronics enclosure may be located, it is desirable for any cooling provision to be robust and able to withstand such environmental conditions whilst not adversely affecting the weight, overall size and cost of the electronics enclosure. As shown in Figure 1, the remote radio head 101 is provided with a solar shield 111, which is so fitted to one side 103 thereof as to leave an air gap 112 between the solar shield 111 and the remote radio head 101.

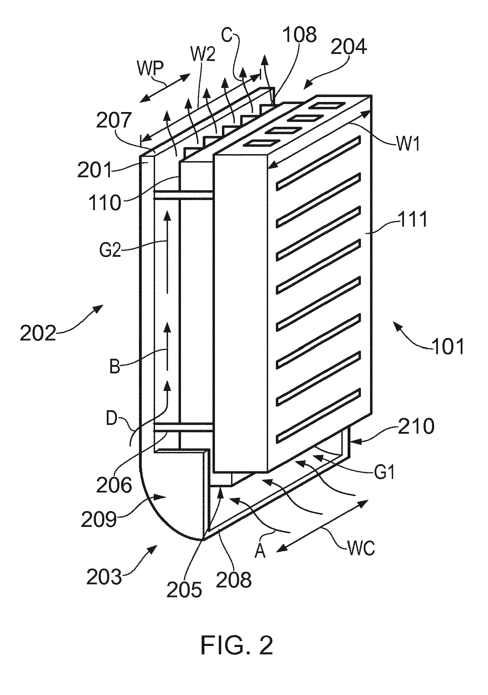

Figure 2 shows an electronic apparatus, which includes an exemplary electronics chassis 101 that generates heat during operation, for example, the RRH of Figure 1, and a wind collector 201 according to a first embodiment. In this Figure, the wind collector 201 is shown arranged for cooling the electronics chassis 101.

The electronics chassis 101 may or may not include a housing around the heat generating electronics therein. Such an optional housing may form an enclosure or may have holes and/or one or more open sides. In some embodiments, the electronics chassis may not have a housing along the side facing the wind collector 201.

The wind collector 201 is a mechanically connected structure, for example, a rigid or flexibly rigid structure, that comprises a heat-exchanger portion 202 and a wind-deflector portion 203. The combination of the heat-exchanger and wind-deflector portions 202, 203 may be formed of one piece or multiple pieces. In an example, the heat-exchange and wind-deflector portions 202, 203 form a continuous surface facing the electronics chassis 101 and are configured to direct an air flow along the facing surface of the electronics chassis 101. The heat-exchanger-portion 202 may be approximately flat or may include curved areas, for example, may have one or more troughs along surface(s) thereof, may be flat, or may be curved. The wind-deflector portion 203 includes a projection located below that may redirect a received airflow, for example, by about 90 degrees or less.

The electronics chassis 101 comprises an upper end 204, a lower end 205, and at least one side face therebetween, such as external surface 110 provided with a series of external heat sink fins 108. The wind collector 201 is mounted on the electronics chassis 101 such that the heat-exchanger portion 202 extends across a side face of the electronics chassis 101 and the wind-deflector portion 203 extends below the lower end 205 of the electronics chassis 101. In the shown arrangement, the wind collector 201 may be secured to the electronics chassis 101 by a plurality of mounting brackets, such as mounting bracket 206 or may be secured to the electronics chassis by other types of conventional fasteners, for example, screws and/or rivets and so on. In an application, such mounting brackets may allow the wind collector to be releasably secured to the electronics chassis 101.

According to this embodiment, the wind-deflector portion 203 extends from the heat-exchanger portion 202 of the wind collector 201. The substantially straight and/or flat portion 202 of the wind collector 201 comprises an upper edge 207 and the wind-deflector portion 203 comprises a lower lip 208, and side walls 209, 210. In this example, the wind collector forms a continuous solid surface that extends between the upper edge 207 and the lower lip 208, for example, and is an integrated structure.

The wind collector 201 allows cooling of the internal environment within the electronics chassis 101 by convective heat transfer via a flow of ambient air between the wind collector 201 and the electronics chassis. For example, the wind-deflector portion 203 of the wind collector 201 can redirect wind to flow between heat-exchanger portion 202 of the wind collector thereby convectively cooling the surface 110 of the electronics chassis 101.

In this Figure, the wind collector 201 is shown mounted to the electronics chassis 101 with the substantially straight and/or flat portion 202 extending across the series of external heat fins 108 of the external surface 110 of the electronics chassis 101, the lower lip 208 of the wind-deflector portion 203 is located below the lower end 205 of the electronics chassis 101, and side walls 209, 210 of the wind-deflector portion 203 are disposed to each side of the bottom corners of the electronics chassis 101 such that a gap G1 is provided between the lower lip 208 and side walls 209, 210 of the wind-deflector portion 203 and the lower end 205 of the electronics chassis 101. The gap G1 is exposed to the external environment and provides a mouth for collecting wind.

For better operation, the wind collector 201 may be arranged on the side opposite to that side of the electronics chassis 101 which faces directly towards known recurring direct wind. Indeed, the side of the electronics chassis 101 facing the wind already directly receives a cooling air flow, and putting the wind collector on the opposite side of the electronics chassis 101 will ensure that the mouth of the wind collector 201 is oriented to also receive such recurring wind.

Preferably, during installation, the gap G1 of the wind collector 201 is oriented to receive the summer time prevailing wind. It is found that positioning to receive the summer time prevailing wind is preferable to a positioning to receive the annual average wind direction since the electronics chassis reaches peak operating temperature during the summer time and additional cooling provided by the wind collector 201 is then of typically of greater benefit. In the shown arrangement, the wind collector 201 is located on the side of the electronics chassis 101 that is opposite to the side of the electronics chassis 101 that is provided with the solar shield 111.

As indicated by arrows A, B and C, air flowing into the wind collector 201 through the gap G1 at the lower end 205 of the electronics chassis 101 (as shown by arrow A) is directed by the wind-deflector portion 203 to flow upwards between the heat-exchanger portion 202 of the wind collector 201 and the external surface 110 of the electronics chassis 101 (as shown by arrow B) and into the external environment at the upper end 204 of the electronics chassis 101 (as shown by arrow C). Air flowing along this air flow path passes over the external surface 110 and possibly external heat fins 108 of the electronics chassis 101 and can provide an additional degree of cooling of the electronics chassis 101 by convectively transporting some heat from the away from the electronics chassis 101. Wind flowing into the wind collector 201 is collected at an entry temperature and is then, typically exhausted from the wind collector 201 at a higher exit temperature.

As can also be seen in this Figure, a gap G2 is provided between the wind collector 201, the external surface 110 of the electronics chassis 101 and a gap may also exist, in some embodiments, between the wind collector 201 and the outermost heat fins of the series of external heat fins 108 at the external surface 110 of the electronics chassis 101. As indicated by arrow D, air may also flow into the gap G2 from the sides of the electronics chassis 101 and then, flow upwards between the heat-exchanger portion 202 of the wind collector 201 and the external surface 110 of the electronics chassis 101 (as shown by arrow B) and then, flow into the external environment at the upper end 204 of the electronics chassis 101 (as shown by arrow C). Air flowing along this air flow path may also pass over the outer facing surface of the end heat fin of any series of external heat fins 108 at the external surface 110 of the electronics chassis 101 further facilitating the convective transport of heat from the away from the electronics chassis 101.

In this example, the heat-exchanger portion 202 of wind collector 201 is substantially planar and the wind-deflector portion 203 extends from the heat-exchanger portion 202, and may direct the airflow through approximately 90 degrees for example to extend substantially perpendicular to the heat exchanger portion 202. In some embodiments, the wind-deflector portion 30 may deflect the received airflow through a much smaller angle, for example, in the range of 90 degrees to 45 degrees. In some embodiments, wind flows into the wind collector 201 through gap G1 substantially horizontally and is directed by the wind-deflector portion 203 to flow substantially vertically along the heat-exchanger portion 202.

The wind collector 201 allows cooling of the electronics chassis 101 by convective heat transfer using a flow of ambient air between the wind collector 201 and the electronics chassis 101. The wind collector 201 also allows a downward flow of precipitation, for example, rain, between the wind collector 201 and the electronics chassis 101. Thus, the wind collector 201 can provide improved cooling through natural convection in conditions of rain.

The wind collector 201 may be fabricated from any suitable material or materials and may have any suitable dimensions, shape and finish. In some embodiments, the wind collector 201 may be fabricated, for example, primarily or completely from aluminium, and in other embodiments, the wind collector 201 may be fabricated, for example, primarily or completely of a polycarbonate plastics material. Desirable characteristics of these materials may include being relatively lightweight, for minimizing weight addition to the electronics chassis 101 and facilitating manual handling.

The wind collector 201 may have any suitable internal and/or external coating or finish. For example, surfaces of the wind collector that are exposed to the general environment may advantageously be provided with a self-cleaning coating.

The size and/or shape of each gap through which air may flow into, or from, the wind collector 201 may vary between applications. Surfaces of the wind collector 201 may have any suitable profile. The degree of any curvature of the wind-deflector portion 203 and/or the heat-exchanger portion 202, in any direction, may also vary between applications. The size and shape of the wind-deflector portion 203 may be modified to vary the cross section presented to wind. The size and shape of the wind-deflector portion 203 may affect the volume and flow rate of collected air between the wind collector 201 and the electronics chassis 101.

The electronics chassis 101 has a maximum width W1 and the wind collector 201 has a maximum width W2. The maximum width W2 of the wind collector 201 may be lesser, greater or equal to the maximum width W1 of the electronics chassis 101. In this illustrated example, the maximum width W2 of the wind collector 201 is equal to or shorter than the maximum width W1 of the electronics chassis 101.

In this embodiment, the heat-exchanger portion 202 and the wind-deflector portion 203 of the wind collector 201 are each rigid, and have a width direction WP, WC respectively. In this embodiment also, the orientation of the width direction WC of the wind-deflector portion 203 relative to the width direction WP of the heat-exchanger portion 202 is fixed.

According to the arrangement of the wind collector 201 of Figure 2, the heat-exchanger portion 202 comprises a mounting plate. It is to be appreciated that the wind-deflector portion 203 may be integral with heat-exchanger portion 202, that is, to form a monolithic structure, or may be permanently or releasably attached to the heat-exchanger portion 202. The latter arrangement allows a selected mounting plate to be used with a selected wind-deflector portion 203, which may be subsequently interchanged with another selected wind-deflector portion 203 as desired. It is further to be understood that each of the wind-deflector portion 203 and the heat-exchanger portion 202 may comprise multiple component elements.

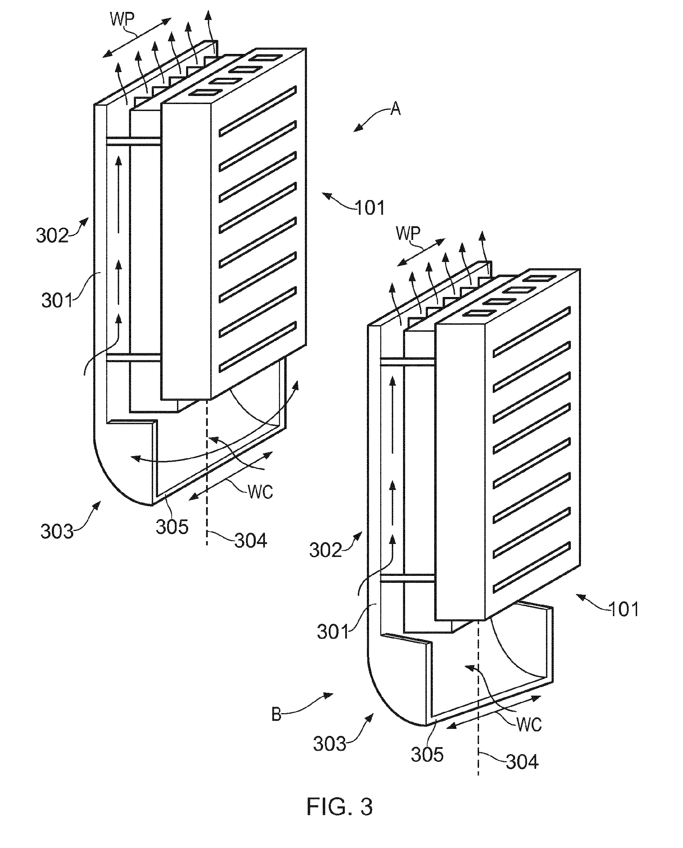

Figure 3 shows an electronic apparatus, which can generate heat during operation and comprises a wind collector 301 according to a second embodiment. In this Figure, the wind collector 301 is shown arranged for providing increased convective cooling to electronics chassis 101. The wind collector 301 is similar to the wind collector 201 of Figure 2 but with differences as described below.

The wind collector 301 comprises a heat-exchanger portion 302 and a wind-deflector portion 303, which have a width direction WP, WC respectively. The wind-deflector portion 303 comprises a lower lip 305. In this embodiment, the orientation of the width direction WC of the wind-deflector portion 303 relative to the orientation of the width direction WP of the heat-exchanger portion 302 is adjustable. According to this embodiment, the heat-exchanger portion 302, or a back plate thereof, is manually configurable to enable modification of the orientation of the wind capture-direction of the wind-deflector portion 303 relative to the width direction WP of the heat-exchanger portion 302.

In this specific example, at least a region of the heat-exchanger portion 302 is fabricated from a pliable material that can be manipulated to adjust the direction in which the lower lip 305 extends relative to the width direction WP of the heat-exchanger portion 302. The configurable region of the heat-exchanger portion 302 may be fabricated from any suitable material that can provide this feature such as an easily deformed material that retains a bent shape after undergoing a mechanical deformation for example.

In Figure 3, the wind collector 301 is shown at A with the wind-deflector portion 303 in the default position relative to the heat-exchanger portion 302 in which the orientations of the width directions WC and WP are substantially parallel. The wind collector 301 is shown at B with the wind-deflector portion 303 twisted from the default position as shown at A, about axis 304, relative to the heat-exchanger portion 302.

In an example, the wind collector 301 allows an adjustment of the wind-deflector portion 303 relative to the heat-exchanger portion 302, for example, up to 45-60 degrees in either direction from the default position shown at A. This may be beneficial for applications in which the wind-deflector portion 303 can be so adjusted as to be oriented to directly face the summer time prevailing wind direction or another direction as desired. After the adjustment of the wind collector 301 has been made, a suitable fixing can be used to secure the adjusted wind-deflector portion 303 in the new position relative to the heat-exchanger portion 302. The fixing may be any suitable mechanical fixing, such as a nut and bolt for example.

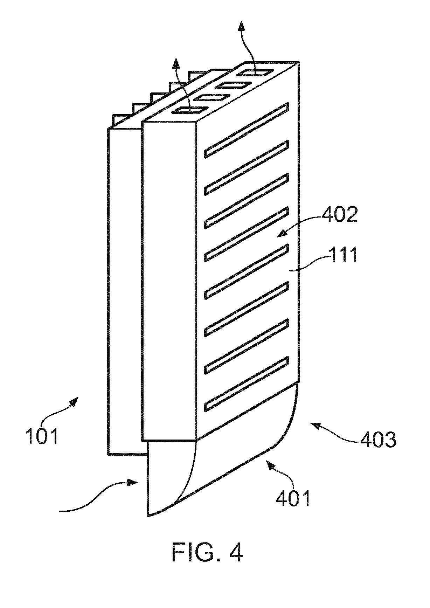

Figure 4 shows an electronic apparatus, which generates heat during operation and comprises a wind collector 401 according to a third embodiment. In this Figure, the wind collector 401 is shown arranged for providing cooling to electronics chassis 101. The wind collector 401 is similar to the wind collector 201 of Figure 2 but with differences as described below.

The wind collector 401 comprises a heat-exchanger portion 402 and a wind-deflector portion 403. In this embodiment, the heat-exchanger portion 402 of the wind collector 401 comprises a surface of the solar shield 111. With the shown arrangement, air flowing into the wind-deflector portion 403 of the wind collector 401 is directed upwards to flow between the electronics chassis 101 and the solar shield 111, for example, along the external heat fins between the electronics chassis 101 and the solar shield 111. In this embodiment, the wind-deflector portion 403 is releasably attached to the electronics chassis 101 using any suitable fixing.

According to the arrangement shown in Figure 4, air flowing into the wind collector 401 is directed by the wind-deflector portion 403 to flow upwards between the heat-exchanger portion 402 of the wind collector 401 and the external surface 109 of the electronics chassis 101 and then into the external environment. Air flowing along this air flow path passes over the external surface 109 and external heat fins 107 of the electronics chassis 101 and provides an additional degree of cooling of the electronics chassis 101 by facilitating the transport of heat from the away from the electronics chassis 101. Wind flowing into the wind collector 401 is collected at an entry temperature and exhausted from the wind collector 401 at a higher exit temperature.

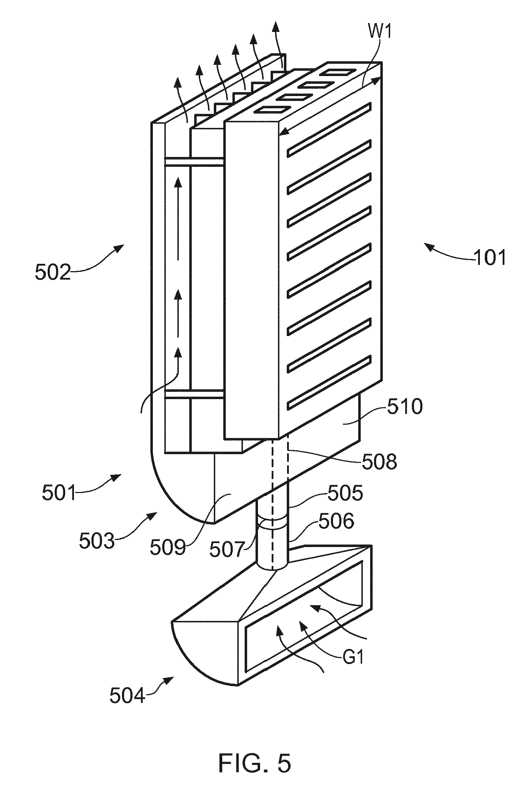

Figure 5 shows cooling apparatus comprising a wind collector 501 according to a fourth embodiment. In this Figure, the wind collector 501 is shown arranged for providing cooling to electronics chassis 101.

The wind collector 501 comprises a heat-exchanger portion 502 and a lower enclosure 503. The wind collector 501 further comprises a rotatable mouth portion 504, that is, a wind-deflector portion that is fluidly connected to the lower enclosure 503. As shown, the rotatable mouth portion 504 is located below the lower enclosure 503, and in turn below the electronics chassis 101. The rotatable mouth portion 504 defines a gap G1 that provides a mouth for collecting wind. In an embodiment, the rotatable mouth portion 504 is rotatable through an angle, for example, an angle of up to 360 degrees. During installation, the rotatable mouth portion 504 can be rotated to a desired orientation, such as to face the summertime prevailing wind direction, and a suitable fixing can be used to secure the rotatable mouth portion 504 in the selected position. The fixing may be any suitable mechanical fixing, or any suitable locking mechanism, which may be repeatedly adjustable.

In this illustrated embodiment, a first pipe 505 extends downwardly from the lower enclosure 503, a second pipe 506 extends upwardly from the rotatable mouth portion 504 and a rotatable bearing 507 is provided between the first pipe 505 and the second pipe 506. At least one internal divider 508 may be provided within the fluid conduit between the rotatable mouth portion 504 and the heat-exchanger portion 502 to form at least two internal regions 509, 510 to each side of the internal divider for distributing the collected wind between the internal regions and across the width W1 of the electronics chassis 101. A more even distribution of collected wind across the width W1 of the electronics chassis 101 may provide a more effective cooling over the area of the side face of the electronics chassis 101 along which the collected wind is directed to flow.

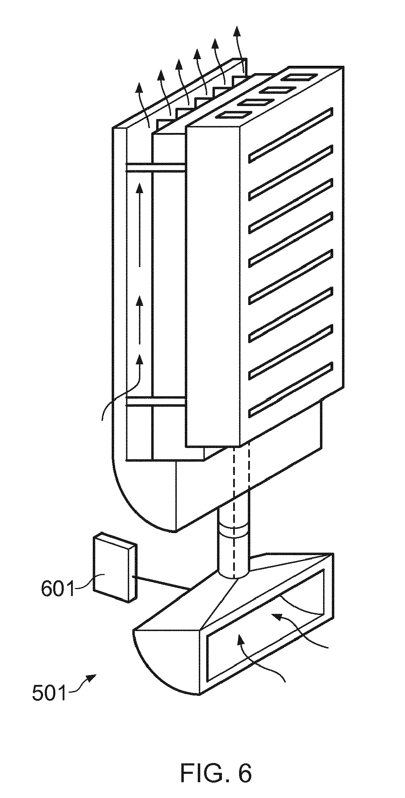

Instead of being fixed at a selected position as described previously, the rotatable mouth portion 504 of the wind collector 501 may be left to freely rotate. As illustrated in Figure 6, the rotatable mouth portion 503 may then be provided with a wind vane 601. In use, the wind vane 601 acts to dynamically position the gap G1 of the rotatable mouth portion 503 so as to face directly towards the direction in which the wind is flowing to improve wind collection and cooling of the electronics chassis 101. This feature may be advantageous in environments with fluctuating wind conditions. The wind vane 601 may be of any suitable type and fabricated from any suitable material or materials, and may have any suitable dimensions, shape and finish.

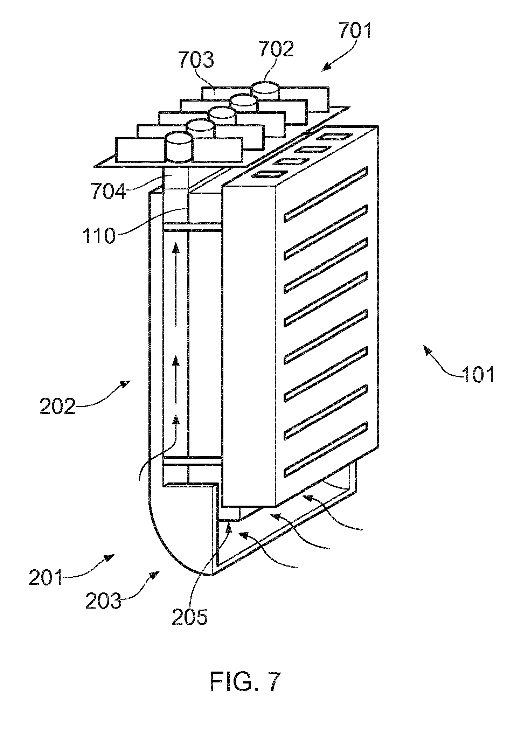

Figure 7 shows a solar collector. In this Figure, the solar collector 701 is shown arranged for cooling electronics chassis 101, in combination with wind collector 201 of Figure 2.

As illustrated, the solar thermal collector 701 comprises a plurality of channels 702. In this example, the solar thermal collector 701 comprises a linear array of tubular channels 702, with a pair of wings 703, extending outwardly from the side wall of each tubular channel 702. The tubular channels 702 of this illustrated example comprise a substantially circular cross-section but may however have any suitable cross-sectional shape.

The solar thermal collector 701 is mountable to the electronics chassis 101 such that the solar thermal collector 701 is located above a side face of the electronics chassis 101 and the channels 702 extend substantially parallel to the plane of the side face. Any suitable fixing may be used to secure, or releasably secure, the solar thermal collector 701 to the electronics chassis 101.

In the shown arrangement, the wind collector 201 is mounted to the electronics chassis 101 such that the heat-exchanger portion 202 extends across a side face 110 of the electronics chassis 101 and the wind-deflector portion 203 extends below the lower end 205 of the electronics chassis 101. The solar thermal collector 701 is mounted to the electronics chassis 101 such that the solar thermal collector 701 is located above the side face 110 of the electronics chassis 101 and the channels 702 extend substantially parallel to the plane of the side face 110 of the electronics chassis 101.

In use, the solar thermal collector 701 is heated by the sun and acts to draw air upwards along a cooling air flow path by natural convection. The solar thermal collector 701 is warmed during periods of direct sunlight and creates convective currents that act to pull ambient air into a cooling air flow path. In this way, the solar thermal collector 701 can encourage air to flow along a cooling air flow path in still conditions.

In the illustrated arrangement, the wind collector 201 is arranged to direct wind upwards along the vertically extending heat fins 108 (not shown in this Figure) of the side face 110 of the electronics chassis 101, and the solar thermal collector 701 is located over the vertically extending heat fins 108 of the side face 110 of the electronics chassis 101. Air flowing upwardly between the heat-exchanger portion 202 of the wind collector 201 and the side face 110 of the electronics chassis 101 can flow upwards through the channels 702 of the solar collector 701 and into the atmosphere.

In this illustrated embodiment, the solar thermal collector 701 is provided with a thermal insulation portion 704 for isolating conductive heat to the solar thermal collector 701. In an application, however, an air gap may be used for this purpose.

Use of the solar thermal collector 701 can be beneficial in conditions of high intensity sunlight.

Another feature associated with the use of the solar thermal collector 701 may be that of providing a degree of shading of the electronics chassis 101 from shadow cast by the solar thermal collector 701.

Although a single solar thermal collector 701 is shown in Figure 7, the electronics chassis 101 may be provided with an additional solar thermal collector, with the second arranged on the opposite side of the electronics chassis to the first, to provide a further degree of cooling, the pair of solar thermal collectors encouraging air flow across the pair of series of external heat fins of the electronics chassis 101.

It is to be appreciated that the solar collector 701 may be used for cooling an electronics chassis 101 independently of the wind collector 201.

The solar thermal collector 701 may be fabricated from any suitable material or materials, and may have any suitable dimensions, shape and finish. In an embodiment, the solar thermal collector is fabricated from metal. In an embodiment, the solar thermal collector is provided with a black carbon coating.

It is to be appreciated that the number, size, shape and arrangement of channels 702 of the solar thermal collector 701, the number, size, shape and arrangement of wings 703 or other surface area increasing elements of the solar thermal collector 701, may vary.

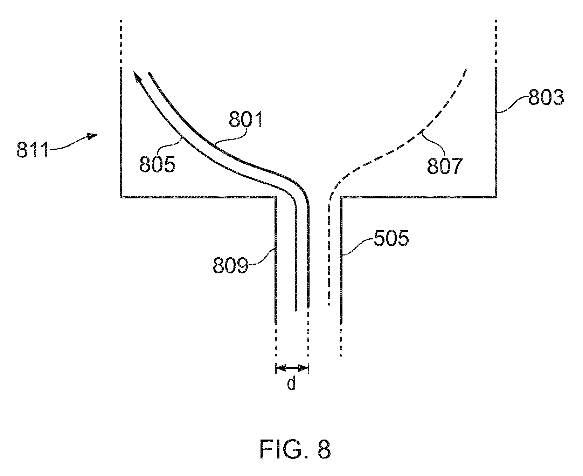

Figure 8 is a schematic representation of a portion of a wind collector, shown in cross-section, according to an example. More particularly, in an alternative arrangement, as illustrated in figure 8, an internal divider 801, or baffle, can be so positioned as to evenly distribute airflow by having the divider arranged on one side of wind collector 803 and shaped, profiled or oriented to provide an airflow to one or more sides of the wind collector.

For example, a divider can curve, so as to substantially match the internal profile of the bottom section of the wind collector for example, and can be offset to one side thereof. Accordingly, the extremity to one side of the wind collector receives an airflow 805. In an example, one or more additional internal dividers can be provided. For example, a divider 807 (shown in broken line) to provide airflow to the other side of the wind collector as shown in figure 8 can be provided so that both sides of the wind collector receive an airflow. Although the divider 801 (and 807) are shown as being curved, they can be any suitable shape. Also, with reference to figure 8, the dividers 801, 807 are depicted extending into the first pipe 505 of the system described with reference to figure 5. The or each divider may also extend into the second pipe 506, or may be provided within a wind deflector portion of a wind collector as herein described.

With reference to the example shown in figure 8, which relates to the wind collector system as exemplified by figure 5 for example, the amount of airflow 805 can be modified by adjusting or otherwise selecting the amount by which the divider 801 extends into the first and/or second pipes of the device. For example, the distance d by which the divider 801 extends from one edge 809 of the first and/or second pipes (505, 506) can be modified or preselected in order to adjust the amount of airflow that can potential be provided to the side 811 of the wind collector 803. Similar considerations can apply to a divider 807 provided to direct a flow of air to another region of the wind collector. Apparatus including an electronics chassis and a wind collector is described herein and such apparatus may include a solar thermal collector. The electronics chassis may be, for example, a remote radio head (RRH).

The wind collector may be beneficially electrically passive, which can advantageously avoid a requirement to electrically power the additional cooling and may also overcome issues of unreliability associated with electrically powered apparatus. Further, the wind collector may not utilise components that could generate undesirable noise. In addition, the wind collector may be static, which may overcome a requirement for servicing of moving parts. The additional cooling enabled by the cooling apparatus described herein allows, in some circumstances, for lower temperature rated cabling or other componentry to be used with an electronics chassis, with an associated cost-saving.

Although illustrative embodiments of the invention have been disclosed in detail herein, with reference to the accompanying drawings, it is understood that the invention is not limited to the precise embodiments shown and that various changes and modifications can be effected therein by one skilled in the art without departing from the scope of the invention as defined by the appended claims and their equivalents.

## Claims

1. An apparatus, comprising
an electronics chassis, said electronics chassis being capable of generating heat during operation, the electronics chassis comprising an upper end, a lower end and at least one side face between the ends; and
a wind collector comprising a heat-exchanger portion and a wind-deflector portion;
said wind collector mounted to said electronics chassis such that said heat-exchanger portion faces and extends along the one side face of said electronics chassis;
said wind-deflector portion extending beyond one of the ends of said electronics chassis and being able to direct part of an external air flow between the heat-exchanger portion and the one side face.

2. The apparatus as claimed in claim 1, wherein said heat-exchanger portion and said wind-deflector portion form a continuous surface facing the electronics chassis.

3. The apparatus as claimed in claim 1, wherein said heat-exchanger portion and said wind-deflector portion each have a width direction and the orientation of the width direction of said wind-deflector portion relative to the width direction of said heat-exchanger portion is adjustable.

4. The apparatus as claimed in claim 1, wherein said heat-exchanger portion is manually configurable to adjust the orientation of said wind-deflector portion relative to said heat-exchanger portion.

5. The apparatus as claimed in claim 1, wherein said wind collector comprises a rotatable mouth portion rotatably connected to said wind-deflector portion.

6. The apparatus as claimed in claim 5, wherein said mouth portion includes a wind vane rigidly connected thereto.

7. The apparatus as claimed in claim 5 or claim 6, wherein said rotatable mouth portion is rotatable through 360 degree rotation.

8. The apparatus as claimed in any of claims 5 to 7, wherein at least one internal divider is provided within a fluid conduit between said rotatable mouth portion and said heat-exchanger portion whereby to distribute collected wind across the width of the electronics chassis.

9. The apparatus as claimed in any preceding claim, wherein said wind collector is monolithic.

10. The apparatus as claimed in any preceding claim, further comprising a solar thermal collector defining a plurality of channels, said solar thermal collector mounted to said electronics chassis such that it is located above a side face of said electronics chassis.

11. The apparatus as claimed in claim 10, wherein the channels extend substantially parallel to the plane of the said side face.

12. The apparatus as claimed in claim 10 or 11, wherein said solar thermal collector is provided with a thermal insulation portion.

13. The apparatus as claimed in any of claims 10 to 12, wherein respective ones of the channels of the thermal collector are provided with a pair of wings extending outwardly from the side wall of the tubular channel.

14. The apparatus as claimed in any preceding claim, wherein the heat-exchanger portion of wind collector is substantially planar; and
the wind-deflector portion extends from the heat-exchanger portion to direct the airflow through an angle in the range 45-90 degrees.

15. A method for cooling an electronics chassis, comprising:
providing a wind collector including a heat exchanger portion and wind deflector portion mountable to the electronics chassis such that the heat exchanger portion faces and extends along one side face of the electronics chassis; and
positioning the wind deflector portion to present an opening thereof to the prevailing wind so as to generate an airflow between the heat exchanger portion and the one side face.
